# EUROPÄISCHE PATENTSCHRIFT

(11) **EP 3 252 480 B1**
(45) Veröffentlichungstag und Bekanntmachung des Hinweises auf die Patenterteilung: **20.06.2018**
(21) Anmeldenummer: 17171494.2
(22) Anmeldetag: 17.05.2017
(51) Int. Cl.: G01R 15/18

(54) **MESSVORRICHTUNG UND MESSVERFAHREN ZUR STROMMESSUNG**
MEASURING DEVICE AND METHOD FOR MEASURING CURRENT
DISPOSITIF DE MESURE ET PROCÉDÉ DE MESURE DE COURANT

(30) Priorität: 02.06.2016 DE 102016110187
(43) Veröffentlichungstag der Anmeldung: 06.12.2017
(73) Patentinhaber: Westsächsische Hochschule Zwickau, 08056 Zwickau (DE)
(72) Erfinder: Bodach, Mirko, 09353 Oberlungwitz (DE); Zacharias, Lutz, 09405 Gornau/Erzg. (DE); Steiner, Kevin, 08112 Wilkau-Haßlau (DE); Franke, Lisa, 08056 Zwickau (DE); Lehmann, Ringo, 08066 Zwickau (DE)
(74) Vertreter: Steiniger, Carmen

(56) Entgegenhaltungen:
- EP-A2- 2 385 380
- EP-A2- 2 551 679
- DE-U1- 29 506 883
- US-A- 3 323 057

## Beschreibung

Die vorliegende Erfindung betrifft eine Messvorrichtung mit einer mit einem ersten Strom unter Ausbildung eines ersten Magnetfeldes speisbaren Primärwicklungseinheit, einer mit einem zweiten Strom unter Ausbildung eines das erste Magnetfeld zumindest teilweise kompensierenden zweiten Magnetfeldes speisbaren Gegenfeldwicklungseinheit und einer Magnetfeldmesseinrichtung zum Erfassen eines von der Primärwicklungseinheit und der Gegenfeldwicklungseinheit ausgebildeten Gesamtmagnetfeldes, wobei die Gegenfeldwicklungseinheit n einzelne, magnetisch in Reihe zueinander geschaltete Gegenfeldwicklungen aufweist, wobei n eine natürliche Zahl und ≥ 2 ist. Die Erfindung betrifft ferner ein Messverfahren, bei dem eine Primärwicklungseinheit einer Messvorrichtung mit einem ersten Strom unter Ausbildung eines ersten Magnetfeldes gespeist wird, eine Gegenfeldwicklungseinheit der Messvorrichtung mit einem zweiten Strom unter Ausbildung eines das erste Magnetfeld zumindest teilweise kompensierenden zweiten Magnetfeldes gespeist wird, durch eine Magnetfeldmesseinrichtung ein von der Primärwicklungseinheit und der Gegenfeldwicklungseinheit ausgebildetes Gesamtmagnetfeld erfasst wird und der zweite Strom so eingestellt wird, dass das Gesamtmagnetfeld zu Null wird.

In der Druckschrift DE 10 2010 043 078 A1 sind eine als Metallsensor verwendete Messvorrichtung sowie ein entsprechendes Messverfahren der oben angegebenen Gattung beschrieben. Die bekannte Messvorrichtung weist zumindest zwei Spulen und einen Magnetfeldsensor auf, wobei die Anordnung der Spulen und des Magnetfeldsensors zueinander sowie der Wicklungssinn der Spulen und/oder der Spulenstrom derart gewählt sind, dass das von den Spulen erzeugte Magnetfeld am Ort des Magnetfeldsensors näherungsweise verschwindet. Taucht im Bereich des von den Spulen erzeugten Magnetfeldes ein metallisches Objekt auf, erzeugt dieses ein von dem Magnetfeldsensor messbares Sekundärfeld, das in der Druckschrift zur Metalldetektion eingesetzt wird.

Darüber existieren im Stand der Technik verschiedene Möglichkeiten zur Strommessung. Dabei besteht ein großer Bedarf an Strommesssystemen, die einen möglichst großen Messbereich besitzen und dennoch mit hoher Genauigkeit messen.

Um diesen Anforderungen gerecht zu werden, wurden im Stand der Technik beispielsweise Strommessvorrichtungen vorgeschlagen, bei welchen für unterschiedliche Strommessbereiche ausgelegte Einzelmessschaltungen miteinander über Schalter verknüpft sind, wobei je nach Anforderung der Messbereich umgeschaltet wird.

So sind beispielsweise aus den Druckschriften US 5,920,189 A, US 4,271,392 A und DE 10 2008 061 996 B4 Strommesssysteme bekannt, die auf einer Anordnung mehrerer elektrischer Shuntwiderstände im Lastkreis des jeweiligen Messsystems basieren. Eine entsprechende elektronische Schaltungsanordnung erfasst zum Messzeitpunkt das vorliegende Messsignal und steuert die Messelektronik an. Durch Umschalten, Hinzuschalten, Kurzschließen oder Überbrücken einzelner Shunts lässt sich ein großer Messbereich abdecken oder automatisch zwischen kleinen Teilbereichen wechseln.

Problematisch ist bei diesen Schaltungen die für das Umschalten zwischen den Shunts erforderliche Schaltzeit, die typischerweise im Millisekundenbereich liegt, wodurch rasche Stromänderungen oder Stromspitzen, die während des Schaltvorganges auftreten, überhaupt nicht registriert werden. Eine kontinuierliche Strommessung ist also mit diesen Systemen nicht möglich.

Soll das Messsystem galvanisch getrennt vom Lastkreis arbeiten und/oder der zu erfassende Gleich- oder Wechselstrom zu Messzwecken herabgesetzt werden, kommen oftmals auch Stromwandler verschiedener Wirkprinzipien zum Einsatz. Modifikationen der Außenbeschaltung erlauben es, ähnlich wie bei den direkten Messverfahren, den Messbereich zu vergrößern oder automatisch zwischen kleineren Teilbereichen zu wechseln. Beispiele hierfür finden sich in den Druckschriften DE 10 2007 030 172 A1 und DD 262 522 A1.

Nachteile dieser Systeme sind insbesondere in der geringen Anzahl der Messbereichsteilbereiche, der nicht gleich bleibenden Auflösung der Messwerte für verschiedene Teilbereiche und der geringen Flexibilität bezüglich der Durchführung von Messungen bei Lösungen mit Anwendung direkter Strommessverfahren zu sehen.

Aus der Druckschrift US 3,323,057 A ist eine Einrichtung zur Messung eines Stroms durch einen ersten Bus in Form eines elektrischen Leiters bekannt, der von einem Kern hoher magnetischer Permeabilität umgeben ist. Um den ersten Bus bildet sich durch den Sromfluss ein Magnetfeld mit positiver Flussrichtung aus. Die Einrichtung weist ferner Gegenwicklungen zu dem ersten Bus auf, durch die ein Magnetfeld mit negativer Flussrichtung aufgebaut wird. Der Kern weist mehrere Luftspalte auf, in denen jeweils ein Hall-Element vorgesehen ist. In jedem Hall-Element wird eine Spannung induziert, die direkt proportional zu der Flussdichte in dem Kern und damit zu dem Strom, der durch den ersten Bus fließt, ist. Somit kann durch eine Spannungsmessung an den jeweiligen Hall-Elementen der Strom durch den ersten Bus gemessen werden.

Um eine Verfälschung der Strommessung durch externe Magnetfelder, die beispielsweise durch einen benachbarten zweiten Bus entstehen, zu verhindern, wird in der Druckschrift US 3,323,057 A vorgeschlagen, jede der Gegenwicklungen mittels einer Rückwärtsstromquelle über Schalterblocks mit Strom zu versorgen und dadurch eine positive Magnetkraft aufzubauen, die die gleiche Richtung und Größenordnung wie die Magnetkraft des ersten Busses aufweist.

Alternativ können zur Kompensation externer Magnetfelder anstelle der Rückwärtsstromquelle separate Wicklungen um den Kern vorgesehen werden, die durch eine Stromquelle gespeist werden, die in dem Kern eine konstante, positive Magnetkraft erzeugt.

Es ist daher die Aufgabe der vorliegenden Erfindung, eine möglichst kostengünstige Messvorrichtung und ein Messverfahren zur Verfügung zu stellen, welche eine kontinuierliche Strommessung mit hoher, vorzugsweise gleich bleibender Messauflösung über einen großen Messbereich ermöglichen.

Die Aufgabe wird zum einen durch eine Messvorrichtung der eingangs genannten Gattung gelöst, die eine mit der Magnetfeldmesseinrichtung gekoppelte Stromversorgungs- und -begrenzerschaltungseinrichtung aufweist, mit der die Gegenfeldwicklungen nacheinander, jeweils bis zu einem der jeweiligen Gegenfeldwicklungseinheit zugeordneten Stromschwellenwert mit dem zweiten Strom versorgt werden, wobei jede der Gegenfeldwicklungen einen von n Teilmessbereichen implementiert.

Die erfindungsgemäße Messvorrichtung basiert auf dem Prinzip der Feldkompensation, bei dem durch die Magnetfeldmesseinrichtung das von der Primärwicklungseinheit und der Gegenfeldwicklungseinheit ausgebildete Gesamtmagnetfeld erfasst wird, wobei der durch die Gegenfeldwicklungseinheit, typischerweise in zu dem ersten Strom entgegengesetzter Richtung fließende zweite Strom so lange erhöht wird, bei das Magnetfeld der Gegenfeldwicklungseinheit das Magnetfeld der Primärwicklungseinheit kompensiert, also das Gesamtmagnetfeld zu Null wird. Aus der Höhe des zweiten Stroms wird dann auf die die Höhe des zu messenden ersten Stromes geschlossen.

Da sich erfindungsgemäß die Gegenfeldwicklungseinheit aus wenigstens zwei magnetisch in Reihe geschalteten einzelnen Gegenfeldwicklungen zusammensetzt, kann der zweite Strom kaskadenartig nacheinander an die einzelnen Gegenfeldwicklungen abgegeben werden. Dabei wird die erste Gegenfeldwicklung so lange mit dem zweiten Strom versorgt, bis deren Stromschwellenwert erreicht wird, woraufhin der den Stromschwellenwert der ersten Gegenfeldwicklung überschreitende Anteil des zweiten Stroms an die zweite Gegenfeldwicklung der Gegenfeldwicklungseinheit abgegeben wird, bis auch bei dieser deren Stromschwellenwert erreicht ist und so weiter. Die geschieht so lange, bis das Gesamtmagnetfeld zu Null wird.

Der zweite Strom wird dabei von der mit der Magnetfeldmesseinrichtung gekoppelten Stromversorgungs- und -begrenzerschaltungseinrichtung erzeugt und an die Gegenfeldwicklungen abgegeben. Die Magnetfeldmesseinrichtung gibt also der Stromversorgungs- und -begrenzerschaltungseinrichtung das Eingangssignal für die Höhe des zweiten Stroms vor. Misst die Magnetfeldmesseinrichtung kein Gesamtmagnetfeld mehr, wird der zweite Strom nicht weiter erhöht.

Bei der erfindungsgemäßen Messvorrichtung können die einzelnen Gegenfeldwicklungen so ausgelegt werden, dass sie für den aufzunehmenden Teilstrom des zweiten Stroms optimal sind, also in dem entsprechenden Strombereich ein gut erfassbares, homogenes Magnetfeld erzeugen, sodass der erste Strom mit hoher Auflösung erfasst werden kann. Durch die Mehrzahl der bei der erfindungsgemäßen Messvorrichtung verwendeten, elektrisch parallel geschalteten bzw. magnetisch in Reihe geschalteten Gegenfeldwicklungen kann der Messbereich der Messvorrichtung je nach Anzahl der Gegenfeldwicklungen weit ausgedehnt werden, wobei die Messauflösung hoch bleibt. Jede der Gegenfeldwicklungen definiert einen Teilbereich des Messbereiches der Messvorrichtung. Bei der erfindungsgemäßen Messvorrichtung findet demnach durch Aufteilung des zweiten Stroms auf die einzelnen Gegenfeldwicklungen eine Quantisierung des Messbereichs statt.

Die Überleitung des den jeweiligen Stromschwellenwert überschreitenden Anteils des zweiten Stroms an die zweite und jede weitere Gegenfeldwicklung erfolgt stufenlos, die Strommessung erfolgt also kontinuierlich. Es erfolgt dabei eine stufenlose Messwertübernahme.

Die erfindungsgemäße Messvorrichtung ist für die Messung von Gleich- als auch von Wechselstrom gleichermaßen gut geeignet.

Die erfindungsgemäße Messvorrichtung ist kostengünstig durch eine Modifikation eines vorhandenen Stromwandler-Messsystems und Verwendung einfacher Schaltungsanordnungen realisierbar.

Mit der erfindungsgemäßen Messvorrichtung zeichnet sich durch eine hohe Linearität sowie Dynamik im Vergleich zu bisherigen Lösungen aus.

Durch Anwendung der erfindungsgemäßen Messvorrichtung bei Stromwandler-Messsystemen werden außerdem hohe Grenzfrequenzen erzielt.

Zudem besitzt die erfindungsgemäße Messvorrichtung den Vorteil der Isolation durch Verzicht auf Shunts im Lastkreis.

Die Strommessung mit der erfindungsgemäßen Messvorrichtung kann über den gesamten Messbereich mit gleich bleibender Auflösung durchgeführt werden, wenn alle der Gegenfeldwicklungen den gleichen Wicklungsdurchmesser und die gleiche Wicklungszahl aufweisen.

In einer bevorzugten Ausführungsform der erfindungsgemäßen Messvorrichtung weist diese eine Addiereinheit auf, in der die durch die einzelnen Gegenfeldwicklungen fließenden Teilströme des zweiten Stroms addiert werden können, wobei aus der ermittelten Summe auf den ersten Strom, den eigentlichen Messstrom, geschlossen werden kann. Die Addiereinheit kann aus analoger und/oder digitaler Rechentechnik ausgebildet sein und die Teilströme aus den n Teilbereichen des Messbereichs der Messvorrichtung zu einem Gesamtstromwert für den zweiten Strom verarbeiten und ausgeben.

Grundsätzlich kann bei der erfindungsgemäßen Messvorrichtung eine beliebige Anzahl von zwei und mehr Gegenfeldwicklungen eingesetzt werden. Es hat sich jedoch aus Kosten- und Platzgründen als besonders effizient erwiesen, wenn die Messvorrichtung drei, vier oder fünf Gegenfeldwicklungen aufweist. Es können jedoch auch mehr als drei Gegenfeldwicklungen zum Einsatz kommen.

Als Magnetfeldmesseinrichtung können bei der vorliegenden Erfindung ein beliebiger oder mehrere beliebige Magnetfeldsensor(en) zum Einsatz kommen. Beispielsweise kann hierfür ein nach dem GMR (giant magnetoresistance)-Effekt arbeitender Magnetfeldsensor oder ein Hall-Sensor verwendet werden.

Die Aufgabe wird ferner durch ein Messverfahren der oben angegebenen Gattung gelöst, bei dem zunächst eine erste Gegenfeldwicklung der n gleiche, elektrisch parallel bzw. magnetisch in Reihe zueinander geschaltete Gegenfeldwicklungen aufweisenden Gegenfeldwicklungseinheit, wobei n eine natürliche Zahl und ≥ 2 ist, mit dem zweiten Strom gespeist wird, und dann, wenn der zweite Strom bei noch vorhandenem Gesamtmagnetfeld einen für jede der Gegenfeldwicklungen vorgegebenen Stromschwellenwert überschreitet, nacheinander entsprechend viele weitere der Gegenfeldwicklungen mit dem den jeweiligen Stromschwellenwert überschreitenden Stromanteil des zweiten Stroms, jeweils bis zum Erreichen des jeweiligen Stromschwellenwertes, gespeist werden.

Das erfindungsgemäße Verfahren arbeitet wie folgt: Der durch die Primärwicklungseinheit fließende, zu messende erste Strom erzeugt um die Primärwicklungseinheit ein erstes Magnetfeld. Dieses wird von der Magnetfeldmesseinrichtung erfasst, welche ein Eingangssignal an die Stromversorgungs- und -begrenzerschaltungseinrichtung abgibt, woraufhin diese den zweiten Strom in Abhängigkeit von der Höhe des Eingangssignals erzeugt. Der zweite Strom wird von der Stromversorgungs- und -begrenzerschaltungseinrichtung nacheinander in Strompaketen, deren Höhe maximal einem der jeweiligen, zu bestromenden Gegenfeldwicklung zugeordneten Stromschwellenwert entspricht, an die einzelnen Gegenfeldwicklungen abgegeben. Diese Stromanteile bzw. Strompakete des zweiten Stroms erzeugen in den jeweiligen Gegenfeldwicklungen Anteile eines zweiten, das erste Magnetfeld nach Erreichen der Endhöhe des zweiten Stroms kompensierenden Magnetfeldes. Aus der Summe der Stromanteile des zweiten Stroms kann auf die Gesamthöhe des zweiten Stroms und darauf auf die Höhe des ersten Stroms geschlossen werden.

Mit dem erfindungsgemäßen Verfahren ist daher über die durch die einzelnen Gegenfeldwicklungen realisierten n Teilmessbereiche eine stufenlose Strommessung mit hoher Auflösung über einen großen Messbereich möglich. Es findet bei dem erfindungsgemäßen Verfahren keine Unterbrechung des Messvorganges statt.

Jede der Gegenfeldwicklungen implementiert einen von n Teilmessbereichen. Die durch die Gegenfeldwicklungen fließenden Teilströme des zweiten Stroms werden jeweils separat mit Stromerfassungseinrichtungen erfasst. Mit einer sich an die Gegenfeldwicklungen anschließenden Messwerterfassungseinheit, wie beispielsweise einer Addiereinheit, können die durch die Gegenfeldwicklungen fließenden Teilströme des zweiten Stroms zusammengefasst, zum Messsignal verarbeitet und dieses ausgegeben werden.

Die durch die mit den Teilströmen des zweiten Stroms durchflossenen n Gegenfeldwicklungen Teilmagnetfelder des zweiten Magnetfeldes kompensieren in der Summe das erste Magnetfeld, wodurch die Magnetfeldmesseinrichtung kein Gesamtmagnetfeld mehr misst. Es erfolgt also eine Rückführung der n Teilmessbereiche der n Gegenfeldwicklungen auf den Messwertaufnehmer, die Magnetfeldmesseinrichtung.

Vorzugsweise ist der Stromschwellenwert für jede der Gegenfeldwicklungen gleich. Dann ergibt sich über den gesamten, großen Messbereich eine gleich bleibende hohe Messauflösung.

Eine bevorzugte Ausführungsform der vorliegenden Erfindung, deren Aufbau, Funktion und Vorteile, wird im Folgenden anhand von Figuren näher erläutert, wobei
- Figur 1: schematisch einen Grundaufbau einer Ausführungsform einer erfindungsgemäßen Messvorrichtung zeigt;
- Figur 2: schematisch eine in der Messvorrichtung von Figur 1 verwendbare erste Stromversorgungsschaltung zeigt;
- Figur 3: schematisch eine in der Messvorrichtung von Figur 1 verwendbare zweite Stromversorgungsschaltung zeigt; und
- Figur 4: schematisch eine in der Messvorrichtung von Figur 1 verwendbare Stromversorgungs- und -begrenzerschaltungseinrichtung zeigt.

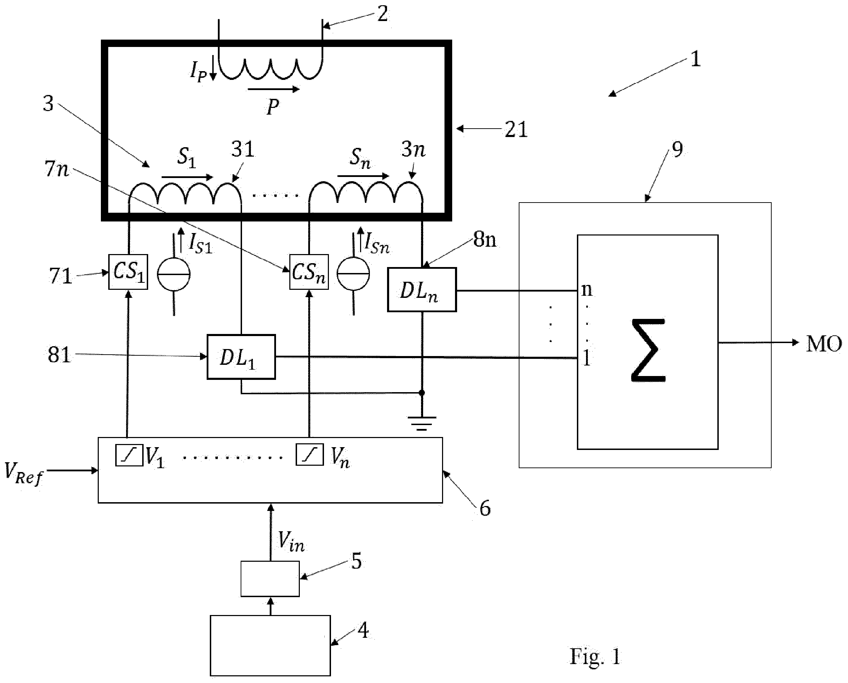

Figur 1 zeigt schematisch einen Grundaufbau einer Ausführungsform einer erfindungsgemäßen Messvorrichtung 1, mit der ein erster Strom I_{P} als Mess- bzw. Primärstrom zu messen ist.

Die Messvorrichtung 1 weist eine Primärwicklungseinheit 2 auf, die mit dem ersten Strom I_{P} speisbar ist bzw. gespeist wird. Die Primärwicklungseinheit 2 ist in dem gezeigten Ausführungsbeispiel eine Spule mit einer bestimmten Wicklungszahl, wobei die Wicklungen einen bestimmten Wicklungsquerschnitt aufweisen. Der erste Strom I_{P} fließt durch die Primärwicklungseinheit in einer ersten Richtung P. Dabei bildet sich um die Primärwicklungseinheit 2 ein erstes Magnetfeld aus.

Im Bereich des ersten Magnetfeldes ist eine aus n separaten Gegenfeldwicklungen 31, ..., 3n ausgebildete Gegenfeldwicklungseinheit 3 vorgesehen. In dem gezeigten Ausführungsbeispiel sind die Gegenfeldwicklungen 31, ..., 3n Spulen mit gleicher Wicklungszahl und gleichem Wicklungsquerschnitt, die über einen Eisenkern 21 magnetisch mit der Primärwicklungseinheit 2 gekoppelt sind.

Die n Gegenfeldwicklungen 31, ..., 3n sind in dem gezeigten Ausführungsbeispiel übereinander gewickelt. Die n Gegenfeldwicklungen 31, ..., 3n werden über eine Stromversorgungs- und -begrenzerschaltungseinrichtung 6 parallel jeweils mit einer Versorgungsspannung V₁, ..., Vₙ bei gemeinsamem Schaltungs-Massebezugspunkt versorgt. Dadurch sind die n Gegenfeldwicklungen 31, ..., 3n magnetisch in Reihe geschaltet.

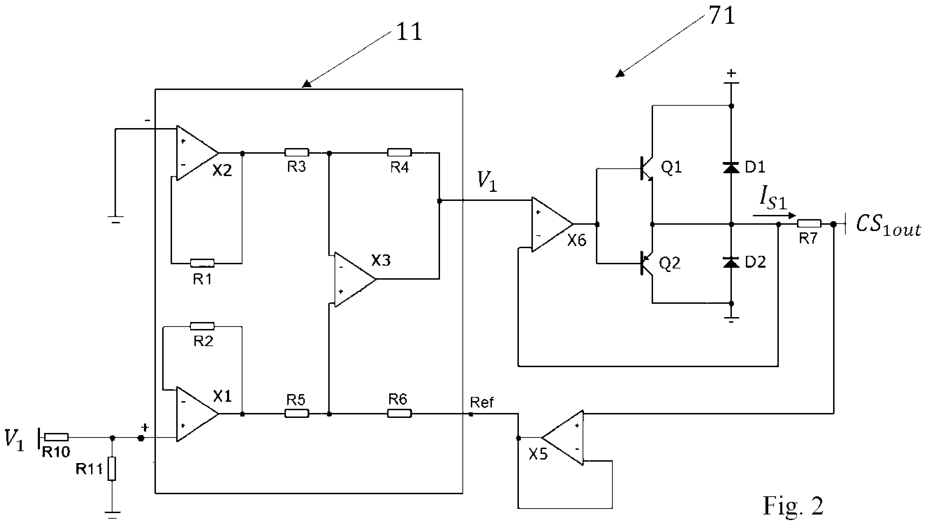

Die Gegenfeldwicklungen 31, ..., 3n können mit Teilströmen I_{S1}, ..., I_{Sn} eines zweiten Stroms gespeist werden. Hierfür ist jede Gegenfeldwicklung 31, ..., 3n mit einer Stromversorgungseinrichtung 71, ..., 7n gekoppelt. Die Stromversorgungseinrichtung 71, mit der die erste Gegenfeldwicklung 31 mit Strom versorgt wird, kann beispielsweise wie die in Figur 2 gezeigte Stromquellenschaltung ausgebildet sein.

Die Stromversorgungseinrichtung 71 von Figur 2 weist Widerstände R1, R2, R3, R4, R5, R6, R7; R10, R11 Operationsverstärker X1, X2, X3, X5, X6, Transistoren Q1, Q2 und Dioden D1, D2 auf.

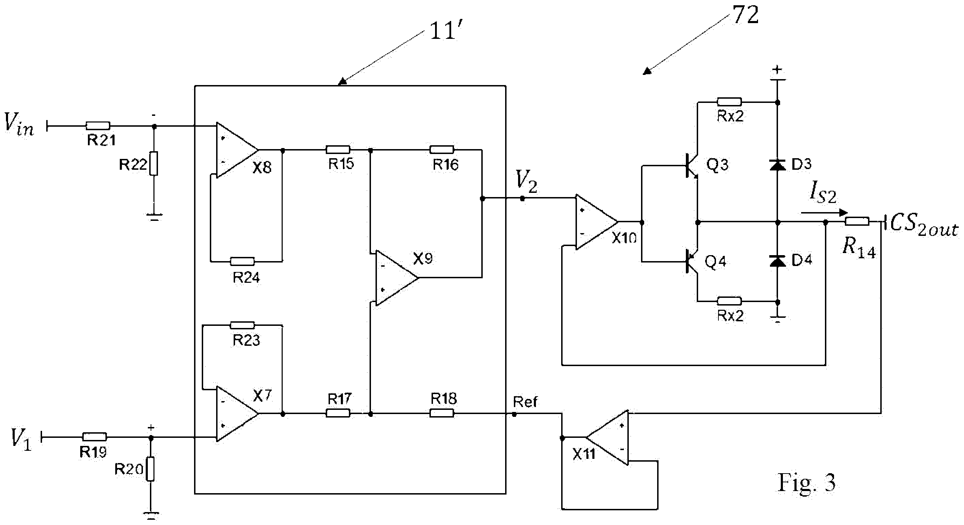

Die Stromversorgungseinrichtung 72 von Figur 3 weist Widerstände R14, R15, R16, R17, R18, R19, R20; R21, R22, Rx2, Operationsverstärker X7, X8, X9, X10, X11, Transistoren Q3, Q4 und Dioden D3, D4 auf.

Durch den zweiten Strom baut sich um die Gegenfeldwicklungseinheit 3 ein zweites Magnetfeld auf. Da der zweite Strom gegenläufig zu dem ersten Strom I_{P} ausgerichtet ist, wie es schematisch durch die Richtungen S₁ und Sₙ der Teilströme I_{S1} und I_{Sn} des zweiten Stroms in Figur 1 angedeutet ist, ist das zweite Magnetfeld so ausgerichtet, dass es das erste Magnetfeld zumindest teilweise kompensiert. Bei einer bestimmten Größe des zweiten Stroms kompensiert das zweite Magnetfeld das erste Magnetfeld an einer durch eine Magnetfeldmesseinrichtung 4 der Messvorrichtung 1 definierten Messstelle vollständig.

Die Magnetfeldmesseinrichtung 4 kann beispielsweise ein auf dem GMR (giant magnetoresistance)-Effekt arbeitender Magnetfeldsensor oder ein Hall-Sensor sein. Die Magnetfeldmesseinrichtung 4, mit ein durch die Primärwicklungseinheit 2 und die Gegenfeldwicklungseinheit 3 erzeugtes Gesamtmagnetfeld erfasst wird, ist über eine Operationsverstärkerschaltung 5 mit einer Stromversorgungs- und -begrenzerschaltungseinrichtung 6 verbunden.

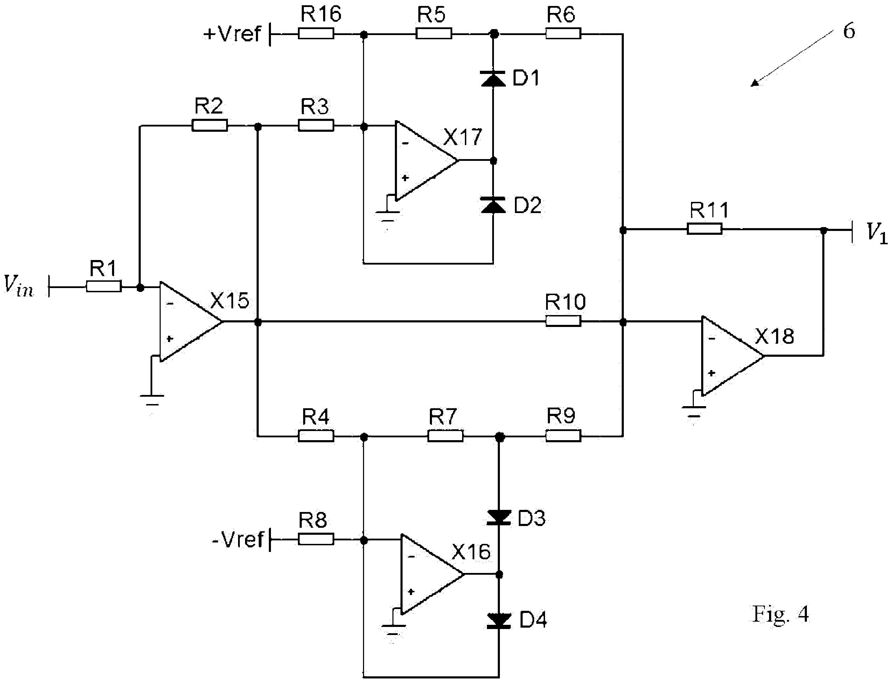

Ein möglicher Schaltungsaufbau der Stromversorgungs- und -begrenzerschaltungseinrichtung 6 ist in Figur 4 gezeigt. Die Stromversorgungs- und -begrenzerschaltungseinrichtung 6 von Figur 4 weist Widerstände R1, R2, R3, R4, R5, R6, R7; R8, R9, R10, R11, R16, Operationsverstärker X15, X16, X17, X18 und Dioden D1, D2 auf.

Das Eingangsspannungssignal Vᵢₙ der Stromversorgungs- und -begrenzerschaltungseinrichtung 6 ist das durch die Operationsverstärkerschaltung 5 aufgearbeitete Messsignal der Magnetfeldmesseinrichtung 4, entspricht also der Höhe des durch die Magnetfeldmesseinrichtung 4 erfassten, durch die Primärwicklungseinheit 2 und die Gegenfeldwicklungseinheit 3 erzeugten Gesamtmagnetfeldes. Das Eingangsspannungssignal Vᵢₙ dient der Regelung des Stromflusses in den Gegenfeldwicklungen 31, ..., 3n.

Durch die Stromversorgungs- und -begrenzerschaltungseinrichtung 6 wird das Eingangsspannungssignal Vᵢₙ mit Zuhilfenahme einer positiven und einer negativen Referenzspannung ± V_{ref} in n Teilspannungen V1, ..., Vₙ, von denen der Spannungspegel jeweils maximal ± V_{ref} beträgt, unterteilt. In dem Beispiel von Figur 4 wird durch die Stromversorgungs- und -begrenzerschaltungseinrichtung 6 die Teilspannung V₁ zur Versorgung der ersten Stromversorgungseinrichtung 71 erzeugt. Die positive Begrenzung erfolgt in dem gezeigten Ausführungsbeispiel mit X17, die negative mit X16. Die Differenz und somit das begrenzte Signal V₁ bildet X18.

Das Ausgangsspannungssignal V₁ der Stromversorgungs- und -begrenzerschaltungseinrichtung 6 ist also das Eingangssignal der mit der Gegenfeldwicklung 31 gekoppelten ersten Stromversorgungseinrichtung 71. Das begrenzte Signal V₁ gelangt hierbei zunächst an einen Instrumentationsverstärker 11 der Stromquelle C_{S1} bzw. der ersten Stromversorgungseinrichtung 71. Den ersten Teilstrom I_{S1} des zweiten Stroms liefern Transistoren Q1 und Q2, welche vom Instrumentationsverstärker 11 in Abhängigkeit von V₁ angesteuert werden. Die in der Schaltung von Figur 2 zwischen dem Instrumentationsverstärker 11 und den Transistoren Q1 und Q2 vorgesehenen Impedanzwandler X5 und X6, die hier als Doppel-OPV ausgebildet sind, aber grundsätzlich auch in dem Instrumentationsverstärker 11 integriert sein können, verhindern einen Stromrückfluss. I_{S1} fließt anschließend, wie in Figur 1 zu sehen, durch die Gegenfeldwicklung 31 und wird von einer Stromerfassungseinrichtung 81 erfasst.

Die erste Stromversorgungseinrichtung 71 erzeugt demnach den ersten Teilstrom I_{S1} des zweiten Stroms. Die in Figur 2 gezeigte Stromquellenschaltung ist eine sehr lineare Stromquelle. Mit ihr wird der Teilstrom I_{S1} zum Bestromen der Gegenfeldwicklung 31 erzeugt. Mit der in Figur 3 gezeigten Stromversorgungseinrichtung 72, insbesondere mit deren Instrumentationsverstärker 11', wird der zweite Teilstrom I_{S2} zum Bestromen einer zweiten Gegenfeldwicklung der Gegenfeldwicklungseinheit 3 erzeugt. I_{S2} fließt anschließend durch die zweite Gegenfeldwicklung und wird anschließend von einer Stromerfassungseinrichtung erfasst.

Wenn ein vorgegebener Stromschwellenwert für den Teilstrom I_{S1} erreicht ist, was durch einen Spannungsbegrenzungswert V_{ref} in der Stromversorgungs- und -begrenzerschaltungseinrichtung 6 definiert ist, wird durch die Stromversorgungs- und -begrenzerschaltungseinrichtung 6 V₁ nicht mehr erhöht. Die dadurch zwischen dem von der Magnetfeldmesseinrichtung 4 der Stromversorgungs- und -begrenzerschaltungseinrichtung 6 zur Verfügung gestellten Eingangsspannungssignal Vᵢₙ und dem Ausgangsspannungssignal V₁ der Stromversorgungs- und -begrenzerschaltungseinrichtung 6 entstehende Differenzspannung wird, wie es aus der in Figur 3 gezeigten Stromversorgungsschaltung 72 hervorgeht, genutzt, um einen zweiten Teilstrom I_{S2} des zweiten Stroms zu erzeugen und damit eine zweite Gegenfeldwicklung der Gegenfeldwicklungseinheit 3 zu bestromen. Dies wird so lange durch sukzessives Nacheinanderbestromen der Gegenfeldwicklungen 31, ..., 3n mit den Teilströmen I_{S1}, ..., I_{Sn} des zweiten Stroms durchgeführt, bis mit Hilfe des durch die Gegenfeldwicklungseinheit 3 fließenden zweiten Stroms das erste Magnetfeld kompensiert ist.

Die von den Stromerfassungseinrichtungen 81, ..., 8n typischerweise digital erfassten Teilstromwerte I_{S1}, ..., I_{Sn} werden daraufhin analog oder digital verarbeitet, wie beispielsweise in der in Figur 1 schematisch dargestellten Addiereinheit 9, und schließlich als Messsignal MO ausgegeben.

## Patentansprüche

1. Messvorrichtung (1) mit einer mit einem ersten Strom (I_{P}) unter Ausbildung eines ersten Magnetfeldes speisbaren Primärwicklungseinheit (2), einer mit einem zweiten Strom unter Ausbildung eines das erste Magnetfeld zumindest teilweise kompensierenden zweiten Magnetfeldes speisbaren Gegenfeldwicklungseinheit (3) und einer Magnetfeldmesseinrichtung (4) zum Erfassen eines von der Primärwicklungseinheit (2) und der Gegenfeldwicklungseinheit (3) ausgebildeten Gesamtmagnetfeldes, wobei die Gegenfeldwicklungseinheit (3) n einzelne, magnetisch in Reihe zueinander geschaltete Gegenfeldwicklungen (31, ..., 3n) aufweist, wobei n eine natürliche Zahl und ≥ 2 ist,
**dadurch gekennzeichnet,**
**dass** die Messvorrichtung (1) eine mit der Magnetfeldmesseinrichtung (4) gekoppelte Stromversorgungs- und -begrenzerschaltungseinrichtung (6, 71; ...; 6, 7n) aufweist, mit der die Gegenfeldwicklungen (31, ..., 3n) stufenweise nacheinander, jeweils bis zu einem der jeweiligen Gegenfeldwicklungseinheit (3) zugeordneten Stromschwellenwert mit dem zweiten Strom versorgt werden, wobei jede der Gegenfeldwicklungen (31, ..., 3n) einen von n Teilmessbereichen implementiert.

2. Messvorrichtung nach Anspruch 1, **dadurch gekennzeichnet, dass** alle der Gegenfeldwicklungen (31, ..., 3n) den gleichen Wicklungsquerschnitt und die gleiche Wicklungszahl aufweisen.

3. Messvorrichtung nach Anspruch 1 oder 2, **dadurch gekennzeichnet, dass** die Messvorrichtung (1) eine Addiereinheit (9) aufweist, in der auf durch die Gegenfeldwicklungen (31, ..., 3n) fließende Teilströme (I_{S1}, ..., I_{Sn}) des zweiten Stroms addierbar sind.

4. Messvorrichtung nach wenigstens einem der vorhergehenden Ansprüche, **dadurch gekennzeichnet, dass** die Messvorrichtung (1) drei, vier oder fünf Gegenfeldwicklungen (31, ..., 3n) aufweist.

5. Messverfahren, bei dem eine Primärwicklungseinheit (2) einer Messvorrichtung (1) mit einem ersten Strom (I_{P}) unter Ausbildung eines ersten Magnetfeldes gespeist wird, eine Gegenfeldwicklungseinheit (3) der Messvorrichtung (1) mit einem zweiten Strom unter Ausbildung eines das erste Magnetfeld zumindest teilweise kompensierenden zweiten Magnetfeldes gespeist wird, durch eine Magnetfeldmesseinrichtung (4) ein von der Primärwicklungseinheit (2) und der Gegenfeldwicklungseinheit (3) ausgebildetes Gesamtmagnetfeld erfasst wird und der zweite Strom so eingestellt wird, dass das Gesamtmagnetfeld zu Null wird,
**dadurch gekennzeichnet,**
**dass** zunächst eine erste Gegenfeldwicklung (31) der n gleiche, magnetisch in Reihe zueinander geschaltete Gegenfeldwicklungen (31, ..., 3n) aufweisenden Gegenfeldwicklungseinheit (3), wobei n eine natürliche Zahl und ≥ 2 ist, mit dem zweiten Strom gespeist wird, und dann, wenn der zweite Strom bei noch vorhandenem Gesamtmagnetfeld einen für jede der Gegenfeldwicklungen (31, ..., 3n) vorgegebenen Stromschwellenwert überschreitet, nacheinander entsprechend viele weitere der Gegenfeldwicklungen (31, ..., 3n) mit dem den jeweiligen Stromschwellenwert überschreitenden Stromanteil des zweiten Stroms, jeweils bis zum Erreichen des jeweiligen Stromschwellenwertes gespeist werden.

6. Messverfahren nach Anspruch 5, **dadurch gekennzeichnet, dass** der Stromschwellenwert für jede der Gegenfeldwicklungen (31, ..., 3n) gleich ist.

7. Messverfahren nach Anspruch 5 oder 6, **dadurch gekennzeichnet, dass** durch die Gegenfeldwicklungen (31, ..., 3n) fließende Teilströme (I_{S1}, ..., I_{Sn}) des zweiten Stroms jeweils separat mit Stromerfassungseinrichtungen (81, ... 8n) erfasst werden.

8. Messverfahren nach Anspruch 7, **dadurch gekennzeichnet, dass** die Teilströme (I_{S1}, ..., I_{Sn}) mit einer Messwerterfassungseinheit zu dem zweiten Strom addiert werden.

## Claims

1. Measuring device (1) with a primary winding unit (2) being feedable with a first current (I_{P}) while forming a first magnetic field, an opposing field winding unit (3) being feedable with a second current while forming a second magnetic field at least partially compensating the first magnetic field and a magnetic field measuring device (4) for recording a total magnetic field being formed by the primary winding unit (2) and the opposing field winding unit (3), wherein the opposing field winding unit (3) comprises n individual opposing field windings (31, ..., 3n) being magnetically connected to each other in series, wherein n is a natural number and ≥ 2,
**characterized in that**
the measuring device (1) comprises an electricity supplying and limiting circuit device (6, 71; ... ; 6, 7n) being coupled with the magnet field measuring device (4), by which the opposing field windings (31, ..., 3n) are supplied gradually one after the other with the second current, each up to a current threshold level being assigned to the respective opposing field winding unit (3), wherein each of the opposing field windings (31, ..., 3n) implements one of n partial measuring ranges.

2. Measuring device according to claim 1, **characterized in that** all of the opposing field windings (31, ..., 3n) comprise the same winding cross section and the same winding number.

3. Measuring device according to claim 1 or 2, **characterized in that** the measuring device (1) comprises an addition unit (9), in which partial currents (I_{S1}, ..., I_{Sn}) of the second current flowing through the opposing field windings (31, ..., 3n) are summable.

4. Measuring device according to at least one of the preceding claims, **characterized in that** the measuring device (1) comprises three, four or five opposing field windings (31, ..., 3n).

5. Measuring method whereby a primary winding unit (2) of a measuring device (1) is fed with a first current (I_{P}) while forming a first magnetic field, an opposing field winding unit (3) of the measuring device (1) is fed with a second current while forming a second magnetic field at least partially compensating the first magnetic field, a total magnetic field being formed by the primary winding unit (2) and the opposing winding unit (3) is recorded by a magnetic field measuring device (4) and the second current is set in such a way that the total magnetic field becomes zero,
**characterized in that**
initially a first opposing field winding (31) of the opposing field winding unit (3) comprising n identical opposing field windings (31, ..., 3n) being magnetically connected to each other in series, wherein n is a natural number and ≥ 2, is fed with the second current and then, as soon as the second current, with the total magnetic field still present, exceeds a current threshold value preset for each of the opposing field windings (31, ..., 3n), many more of the opposing field windings (31, ..., 3n) are accordingly fed one after the other with the current share of the second current exceeding the respective current threshold value, each until reaching the respective current threshold value.

6. Measuring method according to claim 5, **characterized in that** the current threshold value is the same for each of the opposing field windings (31, ..., 3n).

7. Measuring method according to claim 5 or 6, **characterized in that** the partial currents (I_{S1}, ... , I_{Sn}) of the second current flowing through the opposing field windings (31, ..., 3n) are each separately recorded with current recording devices (81, ... 8n).

8. Measuring method according to claim 7, **characterized in that** the partial currents (I_{S1}, ..., I_{Sn}) are added to the second current by means of a measurement value recording unit.

## Revendications

1. Dispositif de mesure (1) comportant une unité d'enroulement primaire (2) pouvant être alimentée avec un premier courant (I_{P}) en formant un premier champ magnétique, une unité d'enroulement à champ inverse (3) pouvant être alimentée avec un deuxième courant en formant un deuxième champ magnétique compensant au moins en partie le premier champ magnétique, ainsi qu'un dispositif de mesure de champ magnétique (4) servant à détecter un champ magnétique global formé par une unité d'enroulement primaire (2) et une unité d'enroulement à champ inverse (3), l'unité d'enroulement à champ inverse (3) comportant n enroulements à champ inverse (31, ..., 3n) individuels montés magnétiquement en série, n étant un entier naturel et ≥ 2,
**caractérisé en ce**
**que** le dispositif de mesure (1) comporte un dispositif d'alimentation électrique et de circuit limiteur de courant (6, 71;...; 6, 7n) couplé au dispositif de mesure de champ magnétique (4) et alimentant avec le deuxième courant les enroulements à champ inverse (31,...,3n) graduellement les uns après les autres jusqu'à une valeur de seuil de courant affectée à ladite unité d'enroulement à champ inverse (3), chacun des enroulements à champ inverse (31,...,3n) mettant en oeuvre une sur n zones de mesure partielle.

2. Dispositif de mesure selon la revendication 1, **caractérisé en ce que** l'ensemble des enroulements à champ inverse (31, ..., 3n) ont la même section transversale d'enroulement et le même nombre d'enroulements.

3. Dispositif de mesure selon la revendication 1 ou 2, **caractérisé en ce que** le dispositif de mesure (1) comporte une unité d'addition (9) dans laquelle des courants partiels, (Iₛ₁, ..., Iₛₙ), traversant les enroulements à champ inverse (31,..., 3n), du deuxième courant peuvent être additionnés.

4. Dispositif de mesure selon au moins une des revendications précédentes, **caractérisé en ce que** le dispositif de mesure (1) comporte trois, quatre ou cinq enroulements à champ inverse (31,..., 3n).

5. Procédé de mesure, dans lequel une unité d'enroulement primaire (2) d'un dispositif de mesure (1) est alimentée avec un premier courant (I_{P}) en formant un premier champ magnétique, une unité d'enroulement à champ inverse (3) du dispositif de mesure (1) est alimentée avec un deuxième courant en formant un deuxième champ magnétique compensant au moins en partie le premier champ magnétique, un champ magnétique global formé par l'unité d'enroulement primaire (2) et l'unité d'enroulement à champ inverse (3) est détecté par un dispositif de mesure de champ magnétique (4), et le deuxième courant est réglé de manière à ce que le champ magnétique global soit **nul,**
**caractérisé en ce**
**qu'**un premier enroulement à champ inverse (31) de l'unité d'enroulement à champ inverse (3) comportant n enroulements à champ inverse (31, ..., 3n) identiques, montés magnétiquement en série, n étant un entier naturel et ≥ 2, est d'abord alimenté avec le deuxième courant, puis lorsque le deuxième courant dépasse une valeur de seuil de courant prédéfinie pour chacun des enroulements à champ inverse (31, ..., 3n) tandis que le champ magnétique global est encore présent, autant d'autres enroulements à champ magnétique (31, ..., 3n) sont alimentés les uns après les autres avec la fraction, dépassant ladite valeur de seuil de courant, du deuxième courant qu'il est possible jusqu'à atteindre ladite valeur de seuil de courant.

6. Procédé de mesure selon la revendication 5, **caractérisé en ce que la** valeur de seuil de courant est identique pour chacun des enroulements à champ inverse (31,..., 3n).

7. Procédé de mesure selon la revendication 5 ou 6, **caractérisé en ce que** des courants partiels (Iₛ₁, ..., Iₛₙ), traversant les enroulements à champ inverse (31,..., 3n), du deuxième courant sont détectés chacun séparément par des dispositifs de détection de courant (81, ... , 8n).

8. Procédé de mesure selon la revendication 7, **caractérisé en ce que** les courants partiels (Iₛ₁, ..., Iₛₙ) sont additionnés pour former le deuxième courant au moyen d'une unité d'acquisition de mesures.
